## Europäisches Patentamt

## European Patent Office

## Office européen des brevets

(19)

(11) Veröffentlichungsnummer: **0 164 383**

**B1**

(12) # EUROPÄISCHE PATENTSCHRIFT

(45) Veröffentlichungstag der Patentschrift:
29.03.89

(51) Int. Cl.⁴: **B 01 J 37/02**, B 01 J 37/34

(21) Anmeldenummer: **85900102.6**

(22) Anmeldetag: **08.12.84**

(86) Internationale Anmeldenummer:
**PCT/EP 84/00394**

(87) Internationale Veröffentlichungsnummer:
**WO 85/02557 (20.06.85 Gazette 85/14)**

(54) **TRÄGER FÜR DIE HERSTELLUNG ABRIEBFESTER KATALYSATOREN.**

(30) Priorität: **08.12.83 DE 3344343**

(43) Veröffentlichungstag der Anmeldung:
**18.12.85 Patentblatt 85/51**

(45) Bekanntmachung des Hinweises auf die Patenterteilung:
**29.03.89 Patentblatt 89/13**

(84) Benannte Vertragsstaaten:
**AT BE CH DE FR GB LI LU NL SE**

(56) Entgegenhaltungen:
**EP-A-0 017 000**
**DE-A-1 717 152**
**DE-A-2 507 636**
**FR-A-859 058**

(73) Patentinhaber: **Battelle- Institut e.V., Am Römerhof 35 Postfach 900 160, D-6000 Frankfurt/Main 90 (DE)**

(72) Erfinder: **STEININGER, Helmut, Dr., Schumannstrasse 12, D-6392 Neu Anspach (DE)**

(74) Vertreter: **Sartorius, Peter, Dipl.- Ing., Battelle-Institut e.V. Abteilung Patente Am Römerhof 35, D-6000 Frankfurt am Main 90 (DE)**

**Beschreibung**

Die Erfindung betrifft einen Träger für die Herstellung abriebfester Katalysatoren, ein Verfahren zu seiner Herstellung sowie seine Verwendung zur Herstellung von Schalenkatalysatoren.

Für katalytische Reaktionen und insbesondere bei oxidierenden Umsetzungen von Kohlenwasserstoffen, Crackreaktionen von niederoktanigen Paraffin-Schnitten zu Brenngasen hoher Klopffestigkeit und Hydrocrackreaktionen werden Schalenkatalysatoren verwendet, die aus Trägern, z. B. in Form von Kugeln, Tabletten oder anderen Formlingen, bestehen, deren Oberfläche schalenförmig mit einer katalytisch aktiven Schicht versehen ist. Die Aufbringung der katalytisch aktiven Masse auf den Träger erfolgt nach naßchemischen Methoden. In der DE-A-3 125 062 wird z. B. ein Verfahren beschrieben, bei dem eine Suspension des Ausgangsmaterials für die Schale auf eine bewegte Schüttung des Trägers aufgesprüht, getrocknet und getempert wird. Nach den in der DE-A-2 814 262 und DE-A-2 909 671 vorgeschlagenen Methoden wird auf die vorbefeuchteten Trägerteilchen in Wasser suspendiertes katalytisch aktives Material aufgesprüht. Alle diese Methoden haben den Nachteil, daß die Haftfestigkeit der Schale nicht zufriedenstellend ist und die Oberflächenstruktur und die Schichtdicke nicht beliebig einstellbar sind.

Die DE-A-2 507 636 beschreibt verschiedene Verfahren zur Aufbringung eines katalytisch aktiven Materials auf einen teilchenförmigen Katalysatorträger. Unter anderem wird das Verfahren der Kathodenzerstäubung mit Ionen aus einer externen Ionenquelle bzw. aus einer Glimmentladung erwähnt, um atomare oder im wesentlichen atomare Dispersionen des abzulagernden Materials zu erzeugen. Hierbei werden also ca. 1 n m starke Schichten undefinierter Morphologie abgeschieden.

Der vorliegenden Erfindung liegt die Aufgabe zubgrunde, einen Katalysatorträger bereitzustellen, der bezüglich der Oberflächenstruktur, Porenverteilung und Oberflächeneigenschaften definiert und reproduzierbar herstellbar ist sowie eine abriebfeste Anordnung der katalytischen Schicht ermöglicht.

Diese Aufgabe ist erfindungsgemäß dadurch gelöst, daß die Oberfläche eines inerten Trägers mit einer durch physikalische Beschichtungsmethoden aufgebrachten Schicht versehen ist, wobei die Schicht aus Einzelstrukturen gebildet ist, die eine Porosität ergeben, und daß die Einzelstrukturen im wesentlichen aus hochschmelzenden Oxiden, Nitriden und/oder Karbiden mindestens eines Übergangselementes, des Bors, Aluminiums und/oder Siliziums oder aus Mischsystemen dieser Verbindungen bestehen. Vorteilhafte Ausführungsformen des erfindungsgemäßen Trägers sind in den Unteransprüchen 2 bis 6 erläutert.

Die Patentansprüche 7 bis 11 betreffen die Herstellung des erfindungsgemäßen Trägers, die Patentansprüche 12 bis 15 seine Verwendung zur Herstellung von Schalenkatalysatoren.

Als Träger werden metallische oder nichtmetallische, wenig poröse oder auch kompakte inerte Materialien verwendet, z. B. Kieselsäureverbindungen, wie Silikate, insbesondere Magnesiumsilikat, Calciumaluminiumsilikat, Tone, Zeolithe und dgl., Kaolin, Aluminiumsilikate, Aluminiumoxide und -hydroxide, Siliciumdioxid, ferner Titandioxid, Zirkondioxid und dgl. Die Form und Größe der Träger können in einen weiten Bereich gewählt werden, z. B. man verwendet tablettierte, körnige und stückige Träger, Pellets oder Kugeln.

Es wurde gefunden, daß für übliche Trägermaterialien Schichten geeignet sind, die aus Oxiden, Nitriden und/oder Karbiden von Übergangselementen bestehen, vorzugsweise von Elementen der IV. bis VI. Nebengruppe des Periodensystems, insbesondere von Titan, Vanadin, Chrom, Zirkon, Molybdän oder Wolfram. Geeignet sind auch Oxide, Nitride oder Karbide des Bors, Aluminiums oder Siliziums. Auch Mischsysteme solcher Verbindungen können verwendet werden, z. B. Carbonitride. Die Art und/oder Zusammensetzung des katalytisch aktiven Materials ist für den erfindungsgemäßen Träger nicht spezifisch. Grundsätzlich kann jedes katalytisch aktives Material eingesetzt werden. Es ist auch möglich, daß die katalytisch aktive Schicht der erfindungsgemäßen Trägerbeschichtung entspricht.

Die Porosität der erfindungsgemäßen Trägerbeschichtung liegt vorzugsweise im Mikrometerbereich und ist verantwortlich für die gute Haftung der katalytisch aktiven Masse. Unter Porosität der Schicht wird erfindungsgemäß eine nicht zusammenhängende Struktur verstanden, wobei sich zwischen den mit der Schicht bedeckten Teilen bis etwa in den Bereich der Trägeroberfläche durchgehende Freiräume befinden. In anderen Worten besteht die Schicht aus mehreren Einzelerhebungen, deren Durchmesser und Höhe im Mikrometerbereich liegen. Auch der Durchmesser der Zwischenräume zwischen den Einzelerhebungen liegen im Mikrometerbereich. Diese Erhebungen sind vorzugsweise stielförmig bzw. stengelig. Die so erzeugten Schichten sind hart und durch die geeignete Einstellung der Textur auch abriebfest.

Erfindungsgemäß wird der Basisträger nach physikalischen Beschichtungsmethoden in Batch - oder Durchlauf - Verfahren in entsprechenden Vakuumbeschichtungsanlagen beschichtet. Physikalische Methoden zur Aufbringung von Schichten einiger Mikrometer Stärke, sogenannte PvD-Verfahren sind bekannt, z. B. Kathodenzerstäubung, Aufdampfen sowie deren Varianten und Kombinationen, wie Ionplating. Durch diese Methoden lassen sich neben homogenen geschlossenen Schichten auch poröse Schichten abscheiden. Letzteren wurde bisher nur wenig Beachtung geschenkt. Erfindungsgemäß wurde jedoch überraschend festgestellt, daß definiert poröse Schichten, die durch physikalische Beschichtungsmethoden hergestellt werden, sich hervorragend als haftvermittelnde Schichten für Katalysatoren, insbesondere Schalenkatalysatoren eignen. Erfindungsgemäß wird der Träger bzw. Trägerteilchen in die Beschichtungsanlage eingebracht und unter anderem zur Beeinflussung der Porosität auf eine vorher festgesetzte Temperatur erwärmt. Dabei darf die Trägertemperatur maximal etwa das 0,3 bis 0,35 bzw. 0.4-fache des Schmelzpunktes des Materials der porösen Schicht betragen. Anschließend wird das Prozessgas in die evakuierte Beschichtungskammer der Anlage eingeleitet. Das Prozessgas besteht aus einem Inertgas, vorzugsweise Argon, und/oder aus Reaktivgasen, z. B. Stickstoff und/oder Kohlenwasserstoffen, Sauerstoff. Die Partialdrücke der eingeleiteten Gase beeinflussen ebenfalls die Porosität. Allgemein gilt, daß mit zunehmende Gasdruck und abnehmender Trägertemperatur der Porositätsgrad zunimmt. Zusätzlich kann der Porositätsgrad durch Anlegen einer Biasspannung beeinflusst werden; die Porosität wird bei zunehmender Biasspannung im allgemeinen vermindert. Durch Variation der Abscheiderate läßt sich der Porositätsgrad ebenfalls einstellen.

Die chemische Zusammensetzung des abzuscheidenden Ausgangsmaterials und die Art und Konzentration der eingeleiteten Reaktivgase bestimmen die Stöchiometrie der Schicht. Ein möglicher Einfluß des erfindungsgemäßen Trägers auf die katalytische Reaktion läßt sich durch Variation der Schicht-Zusammensetzung. z. B. durch Zulegieren von Elementen, beeinflussen. Gemäß den obigen Erklärungen kann dies einerseits erfolgen durch Einleiten weiterer gasförmiger Komponenten. z. B. metallorganische Verbindungen, Kohlenwasserstoffe und dergleichen, oder durch Verwendung eines Ausgangsmaterials entsprechender Zusammensetzung. Die Schicht wird bei geeigneter Parameterwahl, die jeweils leicht festzusetzen ist, in stielförmiger bzw. stengeliger Struktur abgeschieden.

Das katalytisch aktive Material wird auf beschichteten Trägern mit definiert stengeliger Struktur abgeschieden.

Die katalytische aktive Schicht kann ebenfalls durch physikalische Beschichtungsmethoden, wie Aufdampfen, Ionplating, oder Kathodenzerstäubung aber auch durch eine kalte plasmagestützte CVD-Methode erzeugt werden. Die Aufbringung der katalytischen Schicht kann aber auch mit Hilfe von bekannten Methoden, wie sie bei der Beschichtung von Zeolithkatalysatoren angewandt werden, erfolgen, z. B. naßchemisch oder durch Zersetzung von organometallischen Verbindungen in einem konventionellen CVD-Verfahren.

Je nach erforderlicher Dicke der katalytischen Schicht ergeben sich verschiedene Möglichkeiten. Die Stiele bzw. Stengel der Trägerschicht können z. B. sehr dünn mit dem katalytisch aktiven Material überzogen werden, ohne daß die Struktur der Trägerschicht verloren geht. Die Freiräume zwischen der Einzelerhebungen bzw. Stengeln der Schicht können aber auch vollständig mit dem Katalysatormaterial ausgefüllt werden. Ferner kann auch die gesamte Schichtstruktur bedeckt werden, so daß die stengelige Schicht als haftvermittelnde Verzahnung wirkt.

Die Erfindung wird anhand des nachfolgenden Beispiels näher erläutert:

Kugeln aus dichtem α-Aluminiumoxid mit einem Durchmesser von ca. 5 bis 10 mm werden als Träger verwendet. Die Träger werden auf eine Temperatur von ca. 180° C erwärmt. Die Beschichtung wird in einer konventionellen Vakuumbeschichtungsanlage durch Kathodenzerstäubung eines Titankarbid-Targets durchgeführt. Als Prozeßgas wird eine Mischung aus Argon und Acetylen eingeleitet. Der herrschende Argondruck liegt unter Prozeßbedingungen etwa bei 200 bis 3 Pa (2 bis $30.10^{-3}$ mbar); der Druck des zugesetzten Acetylens als Reaktivgas beträgt $8 \cdot 10^{-3} \cdot$ bis 0,1 Pa (ca. $8 \cdot 10^{-5} \cdot$ bis $1 \cdot 10^{-3}$ mbar). Die Dicke der abgeschiedenen Schicht beträgt 1 bis 10 μm, die Porosität ca. 1 μm. Für Zwischenschichten mit geringerer Porosität sind höhere Trägertemperaturen erforderlich.

Die Höhe der Einzelstrukturen beträgt 0,5 bis 20 μm. Die aufgebrachte Schicht enthält in geringer Konzentration andere Elemente, vorzugsweise Metalle.

Die Aktivierung der Zwischenschicht, d.h. die Abscheidung der katalytisch aktiven Masse, wird ebenfalls durch Kathodenzerstäubung in derselben Anlage erzielt. Hierfür wird ausgehend von einem Vanadin- oder Vanadinpentoxid-Target in einer Gasatmosphäre bestehend aus Argon und Sauerstoff reaktiv zerstäubt. Die Schichtdicke beträgt hier maximal 1 μm. Durch geeignete Parameterwahl ist die Katalysatorschicht nicht porös.

## Patentansprüche

1. Inerter Träger für einen Katalysator, dadurch gekennzeichnet, daß auf seine Oberfläche durch PVD-Beschichtungsmethoden eine poröse Zwischenschicht aufgebracht ist, die im wesentlichen aus Einzelstrukturen besteht und zwar im wesentlichen aus hochschmelzenden Oxiden, Nitriden und/oder Karbiden mindestens eines Übergangsmetalls des Bors, Aluminiums und/ oder Siliziums oder aus Mischsystemen dieser Verbindungen.

2. Träger nach Anspruch 1, dadurch gekennzeichnet, daß die Einzelstrukturen aus Erhebungen, Stielen und/oder Stengeln bestehen.

3. Träger nach Anspruch 1 oder 2, dadurch gekennzeichnet, daß die Schichtporösität im Mikrometerbereich liegt.

4. Träger nach einem der Ansprüche 1 bis 3, dadurch gekennzeichnet, daß die Höhe der Einzelstrukturen 0,5 bis 20 µm, vorzugsweise 1 bis 10 µm beträgt.

5. Träger nach einem der Ansprüche 1 bis 4, dadurch gekennzeichnet, daß die Schicht aus Oxiden, Nitriden und/oder Karbiden von Übergangsmetallen der IV. bis VI. Nebengruppe des Periodensystems, vorzugsweise von Titan, Vanadium, Chrom, Zirkonium, Molybdän und/oder Wolfram besteht.

6. Träger nach einem der Ansprüche 1 bis 5, dadurch gekennzeichnet, daß die Schicht in geringer Konzentration andere Elemente, vorzugsweise Metalle, enthält.

7. Verfahren zur Herstellung des Katalysatorträgers nach einem der Ansprüche 1 bis 6, dadurch gekennzeichnet, daß die Oberfläche eines interten Trägers durch PVD-Beschichtungsmethoden unter Anwesenheit eines Prozeßgases aus einem Inertgas und/ oder einem Reaktivgas in an sich bekannter Weise überzogen wird.

8. Verfahren nach Anspruch 7, dadurch gekennzeichnet, daß die Schicht durch Aufdampfen, Ionplating oder Kathodenzerstäubung erzeugt wird.

9. Verfahren nach Anspruch 7 oder 8, dadurch gekennzeichnet, daß die Stöchiometrie der Schicht durch Variation der Zusammensetzung des abzuscheidenden Ausgangsmaterials und die Art und Konzentration von Reaktivgasen im Prozessgas eingestellt wird.

10. Verfahren nach einem der Ansprüche 7 bis 9, dadurch gekennzeichnet, daß der Träger vor der Beschichtung auf eine Temperatur erhitzt wird, die höchstens etwa das 0,3 bis 0,4-fache des Schmelzpunktes des Schichtmaterials beträgt.

11. Verfahren nach einem der Ansprüche 7 bis 10, dadurch gekennzeichnet, daß die Porösität der Schicht durch Variation des Verhältnisses der Partialdrücke der Prozeßgaskomponenten, durch Anlegen einer Biasspannung, durch Einstellen der Temperatur des zu beschichtenden Trägers und/oder der Abscheiderate modifiziert wird.

12. Verwendung des Katalysatorträgers nach einem der Ansprüche 1 bis 6, zur Herstellung von Schalenkatalysatoren.

13. Verwendung nach Anspruch 12, dadurch gekennzeichnet, daß auf die Schicht mit stielförmigen und/oder stengeligen Einzelstrukturen die katalytisch aktive Masse aufgebracht wird.

14. Verwendung nach Anspruch 13, dadurch gekennzeichnet, daß die katalytisch aktive Masse durch Aufdampfen, Ionplating oder Kathodenzerstäubung oder durch ein kaltes plasma gestütztes CVD-Verfahren, aufgebracht wird.

15. Verwendung nach einem der Ansprüche 12 bis 14, dadurch gekennzeichnet, daß das katalytisch aktive Material dem Material der Trägerschicht entspricht.

**Claims**

1. Inert carrier coating for a catalyst, comprising: depositing, by means of PVD coating methods, a porous intermediate layer which consists essentially of individual structures, i.e. essentially of high-melting-point oxides, nitrides and/or carbides of at least one transition metal such as boron, aluminium and/or silicon, or of mixed systems of these compounds.

2. Carrier as claimed in Claim 1, wherein the individual structures consist of elevations, stalks and/or columns.

3. Carrier as claimed in Claim 1 or Claim 2, wherein the porosity of the coating is in the micrometer range.

4. Carrier as claimed in any of the Claims 1 to 3, wherein the height of the individual structures is 0.5 to 20 µm, preferably 1 to 10 µm.

5. Carrier as claimed in any of the Claims 1 to 4, wherein the coating consists of oxides, nitrides and/or carbides of transition metals of groups IV to VI of the periodic system, preferably of titanium, vanadium, chromium, zirconium, molybdenum and/or tungsten.

6. Carrier as claimed in any of the Claims 1 to 5, wherein the coating contains low concentrations of other elements, preferably metals.

7. Method of producing the catalyst carrier as claimed in any of the Claims 1 to 6, wherein the surface of an inert substrate is coated in a known manner by PVD coating methods in the presence of a process gas consisting of an inert gas and/or a reactive gas.

8. Method as claimed in Claim 7, wherein the coating is produced by evaporation, ion plating or cathode sputtering.

9. Method as claimed in Claim 7 or Claim 8, wherein stoichiometry of the coating is adjusted by varying the composition of the starting material to be deposited and type and concentration of reactive gases in the process gas.

10. Method as claimed in any of the Claims 7 to 9, wherein, prior to coating, the substrate is heated up to a temperature which does not exceed about the 0.3 - to 0.4-fold of the melting point of the coating material.

11. Method as claimed in any of the Claims 7 to 10, wherein the porosity of the coating is modified by varying the ratio of the partial pressures of the process gas components, by applying a bias voltage, by adjusting the temperature of the substrate to be coated and/or the deposition rate.

12. Use of the catalyst carrier as claimed in any of the Claims 1 to 6 to produce shell catalysts.

13. Use as claimed in Claim 12, wherein the catalytically active material is applied to the coating with stalked and/or columnar individual structures.

14. Use as claimed in Claim 13, wherein the catalytically active material is applied by evaporation, ion plating or cathode sputtering, or by a cold plasma-assisted CVD method.

15. Use as claimed in any of the Claims 12 to 14, wherein the catalytically active material corresponds to the material of the carrier coating.

**Revendications**

1. Support inerte pour un catalyseur caractérisé en ce que, sur sa surface, est déposée une couche intermédiaire poreuse par revêtement PVD, qui pour l'essentiel est constituée de structures indépendantes et pour l'essentiel d'oxydes, de nitrures et/ou de carbures réfractaires d'un métal de transition de bore, d'aluminium et/ou de silicium ou d'un système mixte de ces composés.

2. Support selon la revendication 1, caractérisé en ce que les structures indépendantes consistent en bosses, tiges et/ou aiguilles.

3. Support selon la revendication 1 ou 2, caractérisé en ce que la porosité de couche se situe dans le domaine du micron.

4. Support selon l'une des revendications 1 à 3, caractérisé en ce que la hauteur des structures indépendantes est de 0,5 à 20 μm, de préférence 1 à 10 μm.

5. Support selon l'une des revendications 1 à 4, caractérisé en ce que la couche est constituée d'oxydes, de nitrures et/ou de carbures de métaux de transition des IV ème au VI ème sous-groupe du système périodique, de préférence du titane, vanadium, chrome, zirconium, molybdène et/ou tungstène.

6. Support selon l'une des revendications 1 à 5, caractérisé en ce que la couche contient d'autres éléments en plus faible concentration, de préférence des métaux.

7. Procédé de préparation du support de catalyseur selon l'une des revendications 1 à 6, caractérisé en ce que la surface d'un support inerte est revêtue d'une manière connue en soi par des procédés de revêtement PVD en présence d'un gaz de processus comprenant un gaz inerte et/ou un gaz réactif.

8. Procédé selon la revendication 7, caractérisé en ce que la couche est préparée par pulvérisation, bombardement ionique ou pulvérisation cathodique.

9. Procédé selon la revendication 7 ou 8, caractérisé en ce que la stoechiométrie de la couche est réglée par des variations de la composition du matériau de départ à déposer et la nature et la concentration de gaz réactifs dans le gaz de processus.

10. Procédé selon l'une des revendications 7 à 9, caractérisé en ce que le support est porté à une température avant la pulvérisation qui est voisine au plus de 0,3 à 0,4 fois le point de fusion du matériau de couche.

11. Procédé selon l'une des revendications 7 à 10, caractérisé en ce que la porosité de la couche peut être modifiée par variation du rapport des pressions partielles des composants du gaz de processus par application d'une tension, par fixation de la température du support à recouvrir et/ou de la vitesse de dépôt.

12. Utilisation du support de catalyseur selon l'une des revendications 1 à 6 pour la préparation de catalyseurs en coque.

13. Utilisation selon la revendication 12, caractérisée en ce que sur la couche à structures indépendantes en tiges et/ou en aiguille, on dépose la masse catalytiquement active.

14. Utilisation selon la revendication 13, caractérisée en ce que la masse catalytiquement active est déposée par vaporisation, bombardement ionique ou pulvérisation cathodique ou par procédé CVD assisté par plasma froid.

15. Utilisation selon les revendications 12 à 14, caractérisée en ce que le matériau catalytiquement actif correspond au matériau de la couche porteuse.